# DEMANDE DE BREVET EUROPEEN

(11) **EP 1 104 938 A1**
(43) Date de publication de la demande: **06.06.2001**
(21) Numéro de dépôt: 99124206.6
(22) Date de dépôt: 03.12.1999
(51) Int. Cl.: H01L 27/118, H01L 27/02, H01L 29/94, H01L 29/93

(54) **Circuit intégré basse puissance ayant des capacité de découplage**

(71) Demandeur: EM Microelectronic-Marin SA, 2074 Marin (CH)
(72) Inventeur: Fabrice, Walter, CH-2074 Marin (CH); Stiglic, Maksimilijan, Sl-2000 Maribor (SL)
(74) Mandataire: Ravenel, Thierry Gérard Louis

(57) **Abrégé**

Le circuit intégré basse puissance à capacité de découplage comprend au moins un régulateur de tension pour alimenter électriquement au moins un premier et un deuxième rails d'alimentation électrique (4, 5), des premières lignes d'alimentation (6) reliées au premier rail, des secondes lignes d'alimentation (7) reliées au deuxième rail, et des rangées de cellules (1) ayant des cellules à circuit logique (2) et des cellules de remplissage (3) pour le passage de pistes conductrices (8) de connexion entre cellules à circuit logique. Chaque rangée de cellules (1) est connectée et insérée entre une première ligne d'alimentation (6) et une deuxième ligne d'alimentation (7) pour recevoir une alimentation électrique basse puissance. Dans la majeure partie des cellules de remplissage (3), une capacité de découplage (30) est réalisée et connectée entre les première et deuxième lignes d'alimentation.

## Description

L'invention concerne un circuit intégré basse puissance à capacité de découplage comprenant au moins un régulateur de tension fournissant une alimentation électrique basse puissance à au moins un premier et un deuxième rails d'alimentation électrique, des premières lignes d'alimentation reliées au premier rail, des secondes lignes d'alimentation reliées au deuxième rail d'alimentation, et des rangées de cellules ayant des cellules à circuit logique et des cellules de remplissage pour le passage de pistes conductrices de connexion entre cellules à circuit logique, chaque rangée de cellules étant connectée et insérée entre une première ligne d'alimentation et une deuxième ligne d'alimentation pour recevoir une alimentation électrique basse puissance.

Pour opérer à basse puissance, la tension interne doit être la plus basse possible, c'est pourquoi des régulateurs de tension sont prévus dans des circuits intégrés de ce type pour alimenter les parties digitales et analogiques du circuit intégré. Ces régulateurs de tension ont besoin d'être stabilisés par une importante capacité de stabilisation. Cette capacité est habituellement montée externe au circuit intégré. Elle est reliée à une plage de connexion prévue sur le circuit intégré ce qui engendre une perte de place.

Certaines applications exigent également de limiter le maximum de composants électroniques externes à proximité du circuit intégré, par exemple lors de la conception de cartes intelligentes, où le gain en place et en épaisseur de la circuiterie électronique sont des facteurs importants. Le montage d'une capacité de découplage externe sur une carte à puce pour la stabilisation des régulateurs de tension du circuit intégré n'est en principe pas possible.

La plupart des réalisations de circuits intégrés basse puissance, notamment pour être montés sur des cartes à puce, utilisent des portes logiques pour réaliser certaines fonctions ou opérations. En fonctionnement, les portes logiques commutent, ce qui induit un bruit dans le circuit, et consomment du courant sur les lignes d'alimentation. Un filtrage lors de ces opérations entre blocs ou portes logiques devient de ce fait nécessaire.

Plusieurs réalisations de circuits intégrés nécessitant l'emploi de capacités de stabilisation ou de découplage ont fait l'objet de demandes de brevet d'invention.

On peut citer notamment le document japonais JP 8-148578 dans lequel une capacité de découplage est placée à côté de portes logiques, par exemple des inverseurs entre les lignes d'alimentation Vdd et Vss. Cette capacité est constituée de deux plaques métalliques avec une couche d'oxyde ou de nitrure entre lesdites plaques. Il n'est donc pas possible de faire traverser des pistes métalliques au-dessus de telles capacités sans créer un niveau métallique supplémentaire ce qui est un inconvénient.

Dans le but de réduire le temps de réalisation de montages électroniques sur substrat semi-conducteur en phase de prototypes, des circuits intégrés analogiques ou digitaux désignés par la terminologie anglaise semi-custom sont préalablement fabriqués avant le niveau final de métallisation pour la connexion de certaines cellules de chaque circuit intégré de la plaquette. Le document US 4,841,352 décrit un circuit intégré de ce type où il est prévu dans des rangées parallèles de cellules logiques des cellules avec des capacités à connecter selon le montage électronique souhaité. Etant donné que la connexion métallique entre les cellules de ce circuit semi-custom doit pouvoir se faire sans trop de difficultés des espaces sont prévus entre chaque rangée de cellules logiques. Beaucoup de place est néanmoins perdue sur ces types de circuit intégré, car plusieurs cellules logiques ou des cellules à capacité ne sont pas connectées, ce qui est un inconvénient pour une réalisation compacte de circuits intégrés.

Le document US 5,656,834 décrit un circuit intégré avec des capacités de découplage intégrées. Ces capacités de type MOS sont placées sous les rails d'alimentation Vdd et Vss à partir desquels partent des lignes d'alimentation de chaque rangée de cellules à portes logiques. Même si l'enseignement de ce document montre que des capacités de découplage peuvent être réparties et connectées sous lesdits rails d'alimentation faisant un gain de place de 5%, aucune place n'est par contre gagnée par rangée de cellules logiques dans lesquelles des emplacements doivent être prévus pour le passage de pistes conductrices de connexion entre cellules et/ou le croisement de pistes métalliques.

Un circuit intégré CMOS est décrit dans le document EP 0 558 133, dans lequel des capacités sont placées sous les lignes d'alimentation dans des canaux de passage de fils de connexion. Ces capacités sont constituées par des jonctions p-n entre le substrat de type p et une couche de type n connectée au potentiel positif d'une des lignes d'alimentation des rangées de cellules à portes logiques. La tension sur des capacités réalisées par des jonctions p-n ne doit pas trop varier, car la valeur de la capacité diminue exponentiellement avec un accroissement de la tension. De plus, la connexion au potentiel négatif du substrat étant assez éloignée de l'emplacement de ladite capacité cela n'évite pas un effet RC qui n'est pas souhaité.

Le but que se propose de résoudre l'objet de l'invention consiste à intégrer les capacités de découplage dans le circuit intégré en palliant les inconvénients de l'art antérieur cité ci-devant.

Un autre but que se propose de résoudre l'objet de l'invention consiste à réduire la taille des composants et les coûts de fabrication du circuit par l'intégration de capacités de découplage.

Ces buts, ainsi que d'autres, sont atteints grâce au circuit intégré basse puissance du type indiqué ci-dessus qui se caractérise en ce que la majeure partie des cellules de remplissage comprend chacune une capacité de découplage connectée entre une première et une deuxième lignes d'alimentation.

Un avantage de l'intégration des capacités de découplage réparties consiste à fournir des sources d'énergie locale pour des groupes de cellules logiques afin de diminuer le bruit lors de la commutation des portes logiques, d'améliorer la compatibilité électromagnétique et d'éviter des effets RC.

Un autre avantage consiste à rendre plus sûr le circuit intégré basse puissance qui est utilisé principalement dans des systèmes de sécurité grâce aux capacités réparties intégrées. Cette intégration rend de plus en plus difficile une analyse DPA (Differential Power Analysis) des variations de courant ou de tension observées lors des commutations des portes logiques évitant un décryptage de parties secrètes.

Il est à remarquer qu'étant donné que la capacité de découplage est répartie dans une multitude de cellules de remplissage, il n'est plus besoin de prévoir de plage de contact sur le circuit intégré comme dans le cas d'un branchement d'une capacité de découplage externe.

Un avantage de répartir les capacités de découplage dans des cellules de remplissage de chaque rangée de cellules de portes logiques réside en un gain de place afin de compléter chaque portion du circuit perdue. Si chaque cellule vide est remplacée par une telle capacité de découplage cela permet de combler les quelques 20% de place perdue suite au routage des cellules. Chaque cellule de remplissage complétée par une capacité de découplage peut faire partie d'une bibliothèque de cellules au même titre que les cellules à circuit logique afin d'être intégrée à chaque emplacement vide des rangées de cellules lors du placement et du routage du circuit intégré tout en permettant le passage des pistes de connexion entre cellules. L'insertion automatique de ces capacités distribuées n'exige aucun effort de conception (Layout).

Les buts, avantages et caractéristiques du circuit intégré basse puissance apparaîtront mieux, de manière non limitative, dans la description suivante de différentes formes d'exécution illustrées par les dessins sur lesquels :
- la figure 1 représente une vue en plan de la répartition des capacités de découplage avec les cellules à portes logiques sur les rangées de cellules,
- la figure 2 montre une coupe du circuit intégré au niveau d'une cellule de remplissage comprenant une capacité de découplage de type MOS, et
- la figure 3 montre une coupe du circuit intégré au niveau d'une cellule de remplissage comprenant une capacité du type à jonction p-n.

Les circuits intégrés basse puissance, notamment destinés à être montés sur des cartes à puce, sont réalisés sur des substrats semiconducteurs. Il comprennent des régulateurs de tension pour alimenter à une tension la plus basse possible, par exemple à une tension de 2V, une circuiterie analogique et digitale, telle qu'un micro-contrôleur et des interfaces d'entrée et de sortie de signaux électriques.

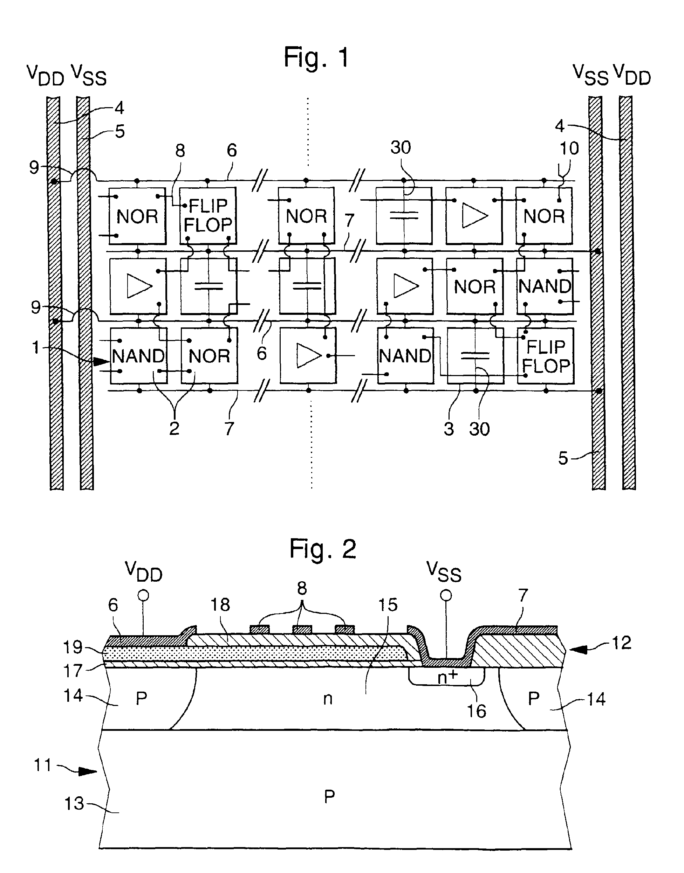

La circuiterie analogique et digitale du circuit intégré, montrée partiellement en figure 1, est composée de rangées de cellules 1 comprenant des cellules à circuit logique 2 et des cellules de remplissage 3 pour le passage de pistes conductrices 8 de connexion entre cellules. Un régulateur de tension, non visible en figure 1, alimente en basse puissance des rails d'alimentation 4 et 5 sous forme de couronne qui entourent lesdites rangées de cellules. Des lignes d'alimentation 6 et 8 sont prévues pour être reliées aux rails d'alimentation pour alimenter en électricité chaque rangée de cellules 1.

Lesdites cellules sont placées en rangées automatiquement par un outil de placement et de routage qui va puiser dans une bibliothèque de cellules afin de réaliser un agencement de cellules aptes à remplir des opérations logiques ou des fonctions spécifiques souhaitées. Pour se fixer un ordre de grandeur et l'utilité d'un outil de placement et de routage, environ 50'000 cellules à portes logiques ou de remplissage sont placées en rangées.

Les cellules sont réalisées par exemple chacune dans un caisson de type N sur un substrat semi-conducteur de type P. Elles sont entourées de zones d'isolation de type P en connexion avec le substrat pour délimiter chaque caisson de type N. Bien entendu toutes les étapes du procédé de réalisation desdites cellules ne sont pas expliquées en détail dans la suite de la description, car elles sont habituelles dans la technologie des semiconducteurs et font partie de la connaissance d'un homme du métier dans ce domaine.

Pour pouvoir travailler correctement, les régulateurs de tension ont besoin d'une importante capacité de stabilisation de l'ordre de quelques nF. Préalablement, la capacité de stabilisation ou de découplage était montée à l'extérieur du circuit intégré ce qui engendrait d'avoir une plage de contact sur ledit circuit intégré pour venir y connecter ladite capacité de découplage. La connexion externe de cette capacité crée le risque de faciliter une analyse (DPA) des variations de courant lors des commutations des portes logiques pour permettre un décryptage d'informations secrètes manipulées par le circuit intégré.

La demanderesse a donc imaginé, au lieu de ne placer que des cellules de remplissage 3 pour le passage de pistes de connexion 8 entre cellules sur une même rangée 1 ou sur une autre rangée, d'intégrer des capacités de découplage 30 dans chacune de ces cellules de remplissage 3 pour servir entre autre de réserve d'énergie pour un groupe de cellules logiques et pour éviter de ce fait un décryptage de parties secrètes du circuit intégré.

Ces cellules de remplissage 3 à capacité de découplage 30 sont donc réparties sur toutes les rangées de cellules 1 et occupent environ le 20% de la place qui était préalablement perdue lors du routage des cellules.

Etant donné la répartition des capacités de découplage 30 dans les cellules de remplissage 3, chaque commutation des portes logiques 2 desdites cellules n'engendrera une fluctuation de tension sur les lignes d'alimentation que localement pour minimiser le bruit généré.

Les rangées de cellules 1 comprennent des circuits logiques 2, par exemple des portes NAND, NOR, des bascules, des inverseurs qui sont connectés entre eux pour remplir les fonctions ou opérations souhaitées. Lors de la connexion entre ces circuits logiques 2 des cellules de remplissage 3 sont placées sur chaque rangée dans lesquelles des capacités de découplage 30 sont intégrées n'empêchant pas le passage des pistes conductrices 8 de connexion. Des ponts 10 pour le passage d'une piste de connexion d'une rangée de cellules 1 à une autre rangée sont possibles lors de la réalisation de plusieurs niveaux de métallisation.

Dans le cadre de l'invention, deux niveaux de métallisation sont suffisants. Toutefois, trois niveaux de métallisation pourraient être souhaitables. Les pistes de connexion 8 sont par exemple à un premier niveau de métallisation et les lignes d'alimentation 6 et 7 sont à un second niveau de métallisation. De ce fait, les pistes de connexion 8 peuvent passer dessous les lignes d'alimentation 6 et 7 pour pouvoir relier des cellules d'autres rangées. Mais, il est également possible de réaliser les lignes d'alimentation 6 et 7 sur un premier niveau de métallisation et les pistes de connexion 8 sur un second niveau de métallisation afin de pouvoir passer au-dessus desdites lignes d'alimentation pour la connexion entre des cellules de rangée différente.

Le régulateur de tension, non visible en figure 1, est alimenté par une source de tension qui peut être une batterie et fournit en sortie une tension régulée qui peut être de l'ordre de 2V par rapport à la masse de la source pour un circuit intégré basse puissance. Pour toute variation de tension de la source d'alimentation, le régulateur de tension fournit une même valeur de tension pour autant que la valeur de tension de la source ne descende pas au-dessous de la tension régulée.

Bien entendu, une régulation de tension peut se faire également par rapport au pôle positif Vdd de la source de tension afin de garder un écart constant de tension entre le pôle positif et la sortie de tension régulée Vss, mais cela n'est pas approprié pour certaines cellules où une variation de tension entre le pôle positif et la masse du substrat semi-conducteur peut modifier certaines caractéristiques de fonctionnement.

Les deux rails d'alimentation 7 et 8 sont alimentés électriquement par le régulateur de tension. Le rail 7 reçoit la tension régulée Vdd du régulateur, tandis que le rail 8 est relié à la terre Vss. Un même écart de tension alimente donc lesdits rails indépendamment de la variation de la source d'alimentation.

Les rails d'alimentation sont configurées habituellement en couronnes d'alimentation placées coaxialement l'une à l'autre sans croisement et entourant les rangées de cellules. La couronne 4 à la tension Vss est placée par exemple à l'intérieur de la couronne 5 à la tension Vdd. Uniquement deux côtés de chaque couronne sont partiellement montrés en figure 1. Les lignes d'alimentation 6 partant d'un côté de la première couronne 4 d'alimentation doivent passer par exemple au-dessus de la seconde couronne 5. Pour ce faire, un pont 9 pour chaque ligne d'alimentation 6 est prévu sur un second niveau de métallisation.

De ces rails d'alimentation 4 et 5 sont tirées perpendiculairement des lignes d'alimentation 6 et 7 pour chaque rangée de cellule 1. Ces lignes sont disposées parallèlement l'une à l'autre.

Plusieurs configurations de connexion des rangées de cellules aux lignes d'alimentation sont envisageables. Dans un premier exemple vu en figure 1, les premières lignes d'alimentation 4 fournissant la tension Vdd partent d'un même côté de la première couronne d'alimentation sans rattachement au côté opposé de ladite première couronne pour définir un premier peigne d'alimentation. Les deuxièmes lignes d'alimentation 7 fournissant la tension Vss, quant à elles, partent d'un côté opposé de la deuxième côté pour définir un second peigne s'imbriquant entre les premières lignes du premier peigne. Une première ligne 6 ou une deuxième ligne 7 d'alimentation est insérée entre chaque rangée de cellules 1 et en alternance pour pouvoir connecter chaque rangée entre une première et une deuxième ligne d'alimentation.

Une deuxième configuration peut consister en ce que les premières lignes d'alimentation partent perpendiculairement depuis un côté de la première couronne pour définir un premier peigne d'alimentation des rangées de cellules, et en ce que les deuxièmes lignes d'alimentation partent perpendiculairement depuis un côté de la deuxième couronne identique à la première couronne pour définir un second peigne d'alimentation des rangées de cellules. Par analogie à la première variante, une première ligne 6 ou une deuxième ligne 7 d'alimentation est insérée entre chaque rangée de cellules 1 et en alternance pour pouvoir connecter chaque rangée entre une première et une deuxième ligne d'alimentation.

Dans une troisième variante similaire à la première variante et dans une quatrième variante similaire à la deuxième variante, il peut être placé entre chaque rangée de cellules 1 une première ligne 6 et une deuxième ligne 7 d'alimentation tout en garantissant que chaque rangée de cellules 1 est connectée entre une première ligne 6 et une deuxième ligne 7 d'alimentation.

Comme défini ci-dessus, les premières lignes et les deuxièmes lignes d'alimentation définissent des peignes avec leur connexion à un unique côté de leur couronne respective, mais on peut concevoir également de relier les premières lignes 6 et les deuxièmes lignes 7 d'alimentation à deux côtés de leur couronne respective.

D'autres configurations peuvent être encore imaginées sans sortir du cadre de l'invention pour autant que leur agencement avec chaque rangée de cellules obtenue à l'aide de l'outil de routage automatique soit compatible.

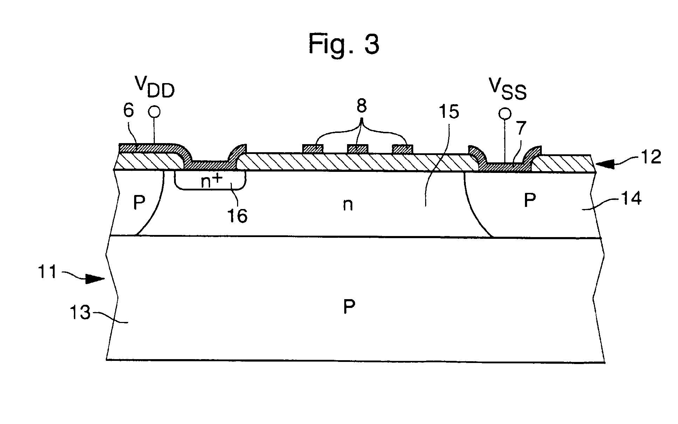

Deux exemples de capacités de découplage sont montrés en coupe aux figures 2 et 3. Des couches d'oxydes 12 servant également à la conception desdites capacités sont réalisées au fur et à mesure de la formation des différents éléments électroniques, tels que les transistors ou les résistances.

En figure 2, la capacité de découplage est une capacité MOS. Une grille 19 de préférence en polysilicium, ou en métal, repose sur une fine couche d'oxyde ou de nitrure 17 obtenue en surface du substrat semi-conducteur 11, et s'étend au-dessus de la surface du caisson 15 de type N de la cellule de remplissage. L'épaisseur de la fine couche d'oxyde ou de nitrure est de l'ordre de 100Å.

Une première ligne d'alimentation 6 connecte la grille 19 pour lui appliquer un potentiel Vdd, alors qu'une deuxième ligne d'alimentation 7 connecte une région 16 de type N+, plus fortement dopée que le caisson 15 pour assurer un meilleur contact électrique, pour lui appliquer un potentiel Vss. Le caisson 15 est entouré de zones d'isolation 14 de type P reliant les zones de base 13 de type P du substrat semi-conducteur 11.

Pour obtenir une valeur de capacité maximale, la grille peut entourer le point de connexion à la région N+ de la deuxième ligne d'alimentation 7 pour couvrir le maximum de surface du caisson 15.

Les pistes métalliques 8 de connexion entre cellules passent au-dessus d'une seconde couche d'oxyde 18 ou de nitrure couvrant la grille 19. Elles ne perturbent donc pas la capacité de découplage de type MOS.

En figure 3, la capacité de découplage est une capacité à jonction p-n. Pour ce faire, le substrat semi-conducteur 11 comprend une zone de base 13 de type P sur laquelle un caisson 15 a été déposé par exemple par une croissance épitaxiale de type N. Le caisson 15 est entouré par une zone d'isolation 14 de type P reliant la zone de base 13. Une région de type N+ 16 fortement dopée est réalisée dans le caisson 15 pour assurer un meilleur contact électrique avec une couche métallique de contact électrique 6.

La première ligne d'alimentation 6 est connectée à la région N+ pour lui appliquer la tension Vdd, alors que la deuxième ligne d'alimentation 7 est connectée à la zone d'isolation 14 entourant le caisson 15 pour lui appliquer la tension Vss. Il aurait pu être envisagé de doper plus fortement la zone de contact entre la deuxième ligne d'alimentation 7 et la zone d'isolation 14 dans le but comme précédemment d'assurer un meilleur contact électrique entre le métal et le semi-conducteur 11.

Comme pour la capacité de type MOS vue en figure 2, les pistes métalliques 8 de connexion entre cellules passent au-dessus d'une couche d'isolation 12 couvrant le caisson 15.

La capacité de découplage est définie par toute la surface de contact entre le caisson de type N et la zone de base 13 et d'isolation 14 de type P et l'épaisseur définie habituellement par la zone de charge d'espace dépendant fortement de la tension présente entre la zone de type N et la zone de type P. Plus la tension est élevée et plus la valeur de capacité diminue de manière exponentielle. Il est donc important de ne pas avoir trop de variation de tension pour une capacité à jonction p-n en fonction d'une valeur de capacité calculée et souhaitée.

Diverses variantes de réalisation de capacités de découplage, insérées dans les cellules de remplissage et faisant partie d'une bibliothèque de cellules pour le routage automatique de la circuiterie analogique et digitale, peuvent être conçues en fonction des connaissances de l'homme du métier dans ce domaine de l'électronique sans sortir du cadre de l'invention

## Revendications

1. Circuit intégré basse puissance à capacité de découplage comprenant au moins un régulateur de tension fournissant une alimentation électrique basse puissance à au moins un premier et un deuxième rails d'alimentation électrique (4, 5), des premières lignes d'alimentation (6) reliées au premier rail, des secondes lignes d'alimentation (7) reliées au deuxième rail d'alimentation, et des rangées de cellules (1) ayant des cellules à circuit logique (2) et des cellules de remplissage (3) pour le passage de pistes conductrices (8) de connexion entre cellules à circuit logique (2), chaque rangée de cellules (1) étant connectée et insérée entre une première ligne d'alimentation (6) et une deuxième ligne d'alimentation (7) pour recevoir une alimentation électrique basse puissance, caractérisé en ce que la majeure partie des cellules de remplissage (3) comprend chacune une capacité de découplage (30) connectée entre une première et une deuxième lignes d'alimentation.

2. Circuit intégré selon la revendication 1, caractérisé en ce que lesdites capacités de découplage (30) réparties dans les cellules de remplissage (3) sont des capacités MOS.

3. Circuit intégré selon la revendication 2, caractérisé en ce que lesdites capacités MOS sont composées verticalement d'une grille en polysilicium (19) ou métallique, d'une fine couche d'oxyde ou de nitrure (17) et d'une région de semi-conducteur de type N (15) ou de type P.

4. Circuit intégré selon la revendication 1, caractérisé en ce que lesdites capacités de découplage (30) réparties dans les cellules de remplissage (3) sont des capacités à jonction p-n où la région de type N (15) est à un potentiel plus élevé que la région de type P (13, 14).

5. Circuit intégré selon la revendication 1, caractérisé en ce qu'il comprend des premiers rails d'alimentation (4) formant une première couronne d'alimentation, et des deuxièmes rails d'alimentation (5) formant une deuxième couronne d'alimentation coaxiale à la première couronne d'alimentation, la première et la deuxième couronnes d'alimentation entourant toutes les rangées de cellules (1).

6. Circuit intégré selon la revendication 5, caractérisé en ce que les premières lignes d'alimentation partent perpendiculairement depuis un côté de la première couronne des premiers rails définissant un premier peigne pour l'alimentation des rangées de cellules, et en ce que les deuxièmes lignes d'alimentation partent perpendiculairement depuis un côté de la deuxième couronne des deuxièmes rails opposé à la première couronne et définissant un second peigne pour l'alimentation des rangées de cellules.

7. Circuit intégré selon la revendication 5, caractérisé en ce que les premières lignes d'alimentation (6) partent perpendiculairement depuis un côté de la première couronne des premiers rails (4) définissant un premier peigne d'alimentation des rangées de cellules (1), et en ce que les deuxièmes lignes d'alimentation (7) partent perpendiculairement depuis un côté de la deuxième couronne des deuxièmes rails (5) identique à la première couronne définissant un second peigne d'alimentation des rangées de cellules (1).

8. Circuit intégré selon la revendication 5, caractérisé en ce que les premières et les deuxièmes lignes d'alimentation sont reliées chacune à un premier côté et à un deuxième côté opposé des couronnes respectives.

9. Circuit intégré selon l'une des revendications 5 à 8, caractérisé en ce qu'une première et une deuxième ligne d'alimentation sont disposées entre chaque rangée de cellules (1).

10. Circuit intégré selon l'une des revendications 5 à 8, caractérisé en ce que chaque rangée de cellules (1) sont séparées par une première ligne d'alimentation (6) ou une deuxième ligne d'alimentation (7) en alternance.

11. Circuit intégré selon la revendication 1, caractérisé en ce que les premières et deuxièmes lignes (6, 7) d'alimentation sont à un second niveau de métallisation alors que les pistes conductrices (8) de connexion entre cellules de rangées différentes sont à un premier niveau de métallisation.

12. Circuit intégré selon la revendication 1, caractérisé en ce que les premières et deuxièmes lignes d'alimentation (6, 7) sont à un premier niveau de métallisation alors que les pistes conductrices (8) de connexion entre cellules de rangées différentes sont à un second niveau de métallisation.

13. Circuit intégré selon la revendication 1, caractérisé en ce que toutes les cellules de remplissage (3) comprennent chacune une capacité de découplage (30).
